**Europäisches Patentamt**

**European Patent Office**

**Office européen des brevets**

(19)

(11) Veröffentlichungsnummer: **0 025 895**

**A1**

(12) **EUROPÄISCHE PATENTANMELDUNG**

(21) Anmeldenummer: **80105131.9**

(22) Anmeldetag: **28.08.80**

(51) Int. Cl.³: **H 03 K 4/02**
**H 04 L 25/49, G 06 G 7/14**

(30) Priorität: **18.09.79 DE 2937697**

(43) Veröffentlichungstag der Anmeldung:
**01.04.81 Patentblatt 81/13**

(84) Benannte Vertragsstaaten:
**AT BE CH DE FR GB IT LI NL SE**

(71) Anmelder: **SIEMENS AKTIENGESELLSCHAFT Berlin
und München
Postfach 22 02 61
D-8000 München 22(DE)**

(72) Erfinder: **Meyer, Fritz, Dr.
Wifostrasse 5
D-8034 Germering(DE)**

(54) **Erzeugung mehrstufiger digitaler Signale aus binären Signalen sehr hoher Bitrate.**

(57) Zur optimalen Ausnutzung der Übertragungskapazität von digitalen Übertragungsstrecken werden häufig binäre Signale zu mehrstufigen digitalen Signalen kombiniert. Dazu werden die binären Signale einer gewichteten Addition unterworfen. Bei sehr hohen Bitraten treten Schwierigkeiten hinsichtlich der exakten Gewichtung und der rückwirkungsfreien Addition auf. Erfindungsgemäß wird eine auf einem basisgekoppelten Differenzverstärker ($T_1$, $T_2$) aufbauende Schaltungsanordnung vorgeschlagen, bei der dem Differenzverstärker eine der Anzahl der Eingangssignale entsprechende Anzahl an emittergekoppelten Differenzverstärkern ($T3, T4....T2n+1, T2n+2$) vorgeschaltet ist.

FIG 1

SIEMENS AKTIENGESELLSCHAFT

Berlin und München

Unser Zeichen
VPA 79 P 6 6 6 8 EUR

Erzeugung mehrstufiger digitaler Signale aus binären Signalen sehr hoher Bitrate

Die Erfindung betrifft eine Anordnung zur Erzeugung $2^n$-stufiger digitaler Signale aus n binären Signalen sehr hoher Bitrate.

Dabei sollen unter binären Signalen sehr hohe Bitrate solcher mit einer Bitrate von wenigstens einigen hundert Mbit/s verstanden werden und $n \geq 2$ sein.

Zur optimalen Ausnutzung der Übertragungskapazität von Übertragungsstrecken für digitale Signale werden diese an den Störabstand im Übertragungskanal und an dessen Bandbreite angepaßt. Bei der Verwendung eines Koaxialkabels als Übertragungsmedium ergibt sich, daß die Streckendämpfung näherungsweise proportional der Quadratwurzel aus der Signalfrequenz ist. Daraus ergibt sich eine sehr schnelle Abnahme des verfügbaren Störabstandes

Ah 1 Bsl / 13.9.1979

bei zunehmender Übertragungsbandbreite. Die optimale Ausnutzung der Übertragungskapazität kann nun dadurch verbessert werden, daß das digitale Signal in eine Form mit mehreren Amplitudenstufen umgewandelt wird und als sogenanntes Mehrstufensignal übertragen wird. Die Stufenzahl wird dabei so gewählt, daß die Kanalkapazität als Produkt aus dem resultierenden Störabstand und der Bandbreite ein Maximum wird.

Die Erzeugung von Mehrstufensignalen erfolgt in der Regel aus binären Ursprungssignalen mittels einer gewichteten Addition. Bei einer gewichteten Addition von binären Signalen sehr hoher Bitrate treten besondere Schwierigkeiten hinsichtlich der exakten Gewichtung und einer rückwirkungsfreien Addition bei kleinem Aufwand auf. Besonders wichtig ist dabei eine Verringerung des Aufwandes, falls die Übertragungstrecke nur eine vergleichsweise geringe Länge aufweist.

Die Aufgabe der Erfindung besteht also darin, eine Schaltungsanordnung der eingangs erwähnten Art anzugeben, bei der sich ein günstiger Kompromiß hinsichtlich Aufwand für die Erzeugung der Mehrstufensignale einerseits und hinsichtlich der Qualität der Ausgangssignale andererseits ergibt.

Erfindungsgemäß wird die Aufgabe durch eine Anordnung entsprechend dem Patentanspruch 1 gelöst. Die angegebene Schaltungsanordnung verzichtet in vorteilhafter Weise auf die Verwendung von Multi-Emittertransistoren, die eventuell aussortiert werden müßten, außerdem ist zumindest eine Teilintegration leicht möglich. Ein vorteilhaft einfacher Aufbau unter Verzicht auf Transistorstromquellen ergibt sich dadurch, daß als Stromquellen ausreichend hochohmige Widerstände vorgesehen sind, deren Widerstandswerte nach Potenzen von 2 gestuft sind.

Zur Anpassung an die üblicherweise verwendeten Logikpegel ist eine Variante der Erfindung zweckmäßig, bei der dem positiveren Potential der binären Eingangssignale der logische Eins-Zustand zugeordnet ist.

Die Erfindung soll im folgenden anhand der Zeichnung näher erläutert werden. In der Zeichnung zeigt

Figur 1 eine Schaltungsanordnung zur Erzeugung eines $2^n$-stufigen digitalen Signals aus n-binären Eingangssignalen im Prinzip,

Figur 2 eine Schaltungsanordnung zur Erzeugung eines quaternären Ausgangssignals aus zwei binären Eingangssignalen in einer detaillierten Darstellung und

Figur 3 ein Impulsdiagramm zu Figur 2.

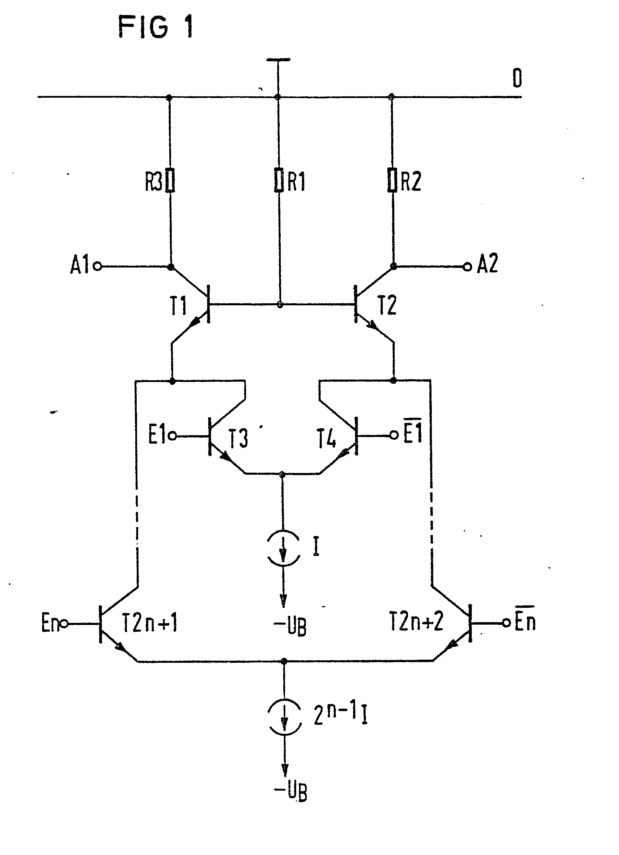

Die in der Figur 1 dargestellte Anordnung dient zur Erläuterung des Schaltungsprinzips, das bei der Erzeugung $2^n$-stufiger Signale aus n-binären Signalen Anwendung findet. Die dargestellte Anordnung enthält einen aus den beiden Transistoren T1, T2 gebildeten basisgekoppelten Differenzverstärker, dem wenigstens zwei emittergekoppelte Differenzverstärker vorgeschaltet sind. Jeder der beiden emittergekoppelten Differenzverstärker dient dabei zur Aufnahme eines Eingangssignals. So nimmt der erste emittergekoppelte Differenzverstärker, der aus den Transistoren T3 und T4 gebildet wird, über die Basisanschlüsse dieser Transistoren das erste Eingangssignal bzw. das erste inverse Eingangssignal auf, und gibt diese Signale an die Emitteranschlüsse des ersten bzw. zweiten Transistors T1, T2 ab, die die Eingangsanschlüsse des basisgekoppelten Differenzverstärkers darstellen. Die Ausgangsanschlüsse dieses basisgekoppelten Differenzverstärkers werden durch die Kollektoranschlüsse der beiden Transistoren gebildet, außerdem sind diese Kollektoranschlüsse über Widerstände R2, R3 mit Bezugspotential 0 verbunden. Mit den Emitteranschlüssen dieser Transistoren sind die Ausgangsanschlüsse weiterer emittergekoppelter Differenzverstärker angeschlossen, wobei für jedes Eingangssignal ein Differenzverstärker vorgesehen ist. Die Verbindung erfolgt dabei so, daß die Kollektoranschlüsse der Transistoren, denen jeweils das betreffende Eingangssignal in Normlage zugeführt wird, mit dem Emitteranschluß des ersten Transistors T1 verbunden sind, während die Kollektoranschlüsse der Transistoren der emittergekoppelten Differenzverstärker, denen das jeweilige Eingangssignal in inverser Form zugeführt wird, mit dem Emitteranschluß des zweiten Transistors T2 des basisgekoppelten Differenzverstärkers verbunden sind.

Die Emitteranschlüsse der die emittergekoppelten Differenzverstärker bildenden Transistoren sind jeweils an eine Stromquelle angeschlossen. Die von den Stromquellen an die einzelnen Differenzverstärker abgegebenen Ströme sind nach Potenzen von 2 gestuft. Dadurch wird die unterschiedliche Bewertung der Eingangssignale erreicht, die für die Erzeugung des mehrstufigen digitalen Signals benötigt wird.

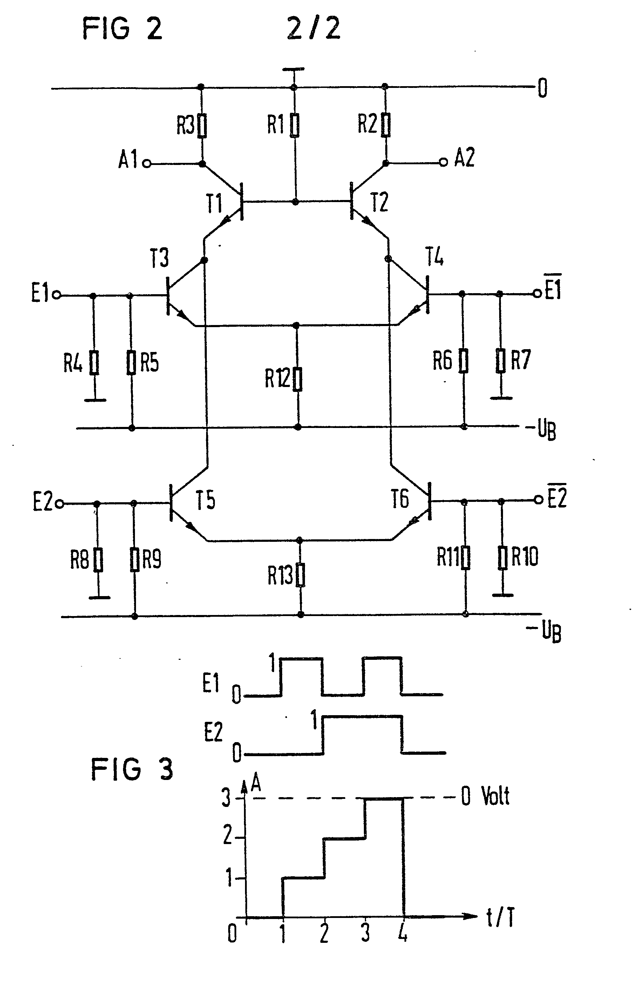

Die in der Figur 2 dargestellte Schaltungsanordnung dient dem in der Praxis wichtigsten Fall, der Erzeugung eines vierstufigen digitalen Signals aus zwei binären Signalen. Der Aufbau dieser Schaltungsanordnung entspricht weitgehend der nach dem Prinzipschaltbild der Fig. 1. Es sind also zwei Transistoren T1 und T2 vorgesehen, deren Basisanschlüsse miteinander und über einengemeinsamen Widerstand mit Bezugspotential verbunden sind. Mit den Kollektoranschlüssen dieser Transistoren ist jeweils ein Ausgangsanschluß A1, A2 verbunden, außerdem sind diese Kollektoranschlüsse getrennt über einen zweiten, dritten Widerstand R2, R3 mit Bezugspotential verbunden. Der Emitteranschluß des ersten Transistors T1 ist mit dem Kollektoranschluß eines dritten und eines fünften Transistors und der Emitteranschluß des zweiten Transistors T2 ist mit dem Kollektoranschluß eines vierten und eines sechsten Transistors verbunden.

Der dritte und der vierte Transistor T3, T4 sind die Hauptteile eines ersten emittergekoppelten Differenzverstärkers zur Verarbeitung des ersten Eingangssignals. Dazu wird dem Basisanschluß des dritten Transistors T3 das Eingangssignal E1 und dem Basisanschluß des vierten Transistors T4 das invertierte Eingangssignal $\bar{E}1$ zugeführt. Der Basisanschluß des dritten Transistors T3 ist außerdem mit einem Mittelabgriff eines aus den Widerständen R4 und R5 gebildeten Basisspannungsteilers verbunden, der Basisanschluß des vierten Transistors T4 ist mit dem aus den Widerständen R6 und R7 gebildeten Basisspannungsteiler verbunden. Die Emitteranschlüsse der Transistoren T4 und T5 sind gemeinsam über einen zwölften Widerstand R12 mit einer Betriebsspannungsquelle -UB verbunden, an die auch die Basisspannungsteiler angeschlossen sind.

Zur Verarbeitung des zweiten Eingangssignals dient der

aus den Transistoren T5 und T6 gebildete Differenzverstärker, dem über die Basisanschlüsse dieser Transistoren das Eingangssignal E2 und das invertierte Eingangssignal E2 zugeführt wird. Die Basisspannung des
Transistors T5 wird mittels des aus den Widerständen
R8 und R9 gebildeten Basisspannungsteilers erzeugt,
die Basisspannung für den Transistor T6 wird mittels
des aus den Widerständen R10 und R11 gebildeten Basisspannungsteilers an den Basisanschluß dieses Transistors abgegeben. Die Emitteranschlüsse der Transistoren
T5 und T6 sind gemeinsam über einen dreizehnten Widerstand R13 mit einer Betriebsspannungsquelle -UB verbunden. Die Widerstände R12 bzw. R13 wurden zu 120 und
zu 60 Ohm gewählt, um die unterschiedliche Bewertung der
Eingangssignale sicherzustellen. Die Kollektorwiderstände der beiden Transistoren T1 und T2 wurden zu etwa 75 Ohm
gewählt, darauf sich Anpassung an ein an den Ausgangsanschluß angekoppeltes Koaxialkabel ergibt.

Die Funktion der Schaltung nach der Figur 2 soll anhand
des Impulsdiagramms nach der Figur 3 kurz erläutert werden. Dabei wird vorausgesetzt, daß dem positiveren Potential der binären Eingangssignale der logische Eins-Zustand entspricht. Ein vierstufiges digitales Signal kann
dementsprechend die Werte 0, 1, 2 und 3 annehmen, wobei
einem höheren Wert ein entsprechend positiveres Potential
zugeordnet ist.

Zunächst kann der Fall betrachtet werden, daß erstes
und zweites Eingangssignal E1 und E2 gleich Null und
deren inverse Werte E1 = E2 = 1 sind. In diesem Falle
wird der Emitter des ersten Transistors T1 gesperrt,
während der Emitter des zweiten Transistors T2 leitet.

Die durch die Widerstände R12 und R13 fließenden Ströme fließen über die Transistoren T4 bzw. T6 und den Transistor T2 und erzeugen am Kollektorwiderstand R2 dieses Transistors das tiefste Potential, das am Ausgangsanschluß A2 den Wert Null signalisiert.

Springt nun das erste Eingangssignal E1 auf den Wert logisch Eins und entsprechend der inverse Wert dieses Signals auf den Wert logisch Null, dann wird der vom Widerstand R12 stammende kleinere Teil des Emitterstroms des Transistors T2 gesperrt. Dadurch entsteht am Kollektoranschluß dieses Transistors ein positiveres Potential, das dem Wert logisch Eins entspricht. Gleichzeitig leitet nun der erste Transistor T1. Die dem Strom I über den Widerstand R12 zugeordneten Ladungen in der Basiszone des zweiten Transistors T2 werden bei diesem Umschaltvorgang direkt in die Basiszone des ersten Transistors T1 übertragen. Hierdurch wird das für die Verarbeitung von binären Signalen sehr hoher Bitraten benötigte äußerst schnelle Umschalten des Stroms von dem Emitter des einen Transistors auf den Emitter des anderen Transistors erreicht, sofern eine Sättigung dieser Transistoren vermieden wird.

Ist bei einem weiteren Impuls das erste Eingangssignal E1 = 0 und das zweite Eingangssignal E2 = 1, dann wird der durch den Widerstand R13 fließende größere Teil des Emitterstroms vom zweiten auf den ersten Transistor umgeschaltet. Am Kollektoranschluß des zweiten Transistors T2 entsteht dadurch ein noch positiveres Potential, das in der Figur 3 dem Wert 2 entspricht.

Sind schließlich beide Eingangssignale E1 und E2 auf
den Wert logisch Eins, dann wird der zweite Multi-Emittertransistor völlig gesperrt, so daß an dessen Kollektoranschluß das positive Potential steht, das in der
Figur 3 dem Wert 3 entspricht.

3 Patentansprüche

3 Figuren

Patentansprüche

1. Anordnung zur Erzeugung $2^n$-stufiger digitaler Signale aus n binären Signalen sehr hoher Bitrate, d a d u r c h g e k e n n z e i c h n e t , daß ein erster und ein zweiter Transistor (T1, T2) vorgesehen sind, deren Basisanschlüsse miteinander und über einen ersten Widerstand (R1) mit Bezugspotential verbunden sind, daß die Kollektoranschlüsse dieser Transistoren jeweils getrennt mit Ausgangsanschlüssen (A1, A2) und über einen zweiten bzw. dritten Widerstand (R2, R3) mit Bezugspotential verbunden sind, daß der Emitteranschluß des ersten Transistors (T1) mit dem Kollektoranschluß eines dritten Transistors (T3) und eines (2n+1)ten Transistors (T 2n+1) verbunden ist, daß der Emitteranschluß des zweiten Transistors (T2) mit dem Kollektoranschluß eines vierten Transistors (T4) und eines (2n+2)-ten Transistors (T 2n+2) verbunden ist, daß der Emitteranschluß des dritten Transistors (T3) mit dem Emitteranschluß des vierten Transistors (T4) und mit einer Stromquelle (I) für den einfachen Strom verbunden ist, daß der Basisanschluß des dritten Transistors (T3) mit dem Anschluß (E1) für ein erstes Eingangssignal und der Basisanschluß des vierten Transistors (T4) mit dem Anschluß (E1) für ein erstes inverses Eingangssignal verbunden ist, daß der Emitteranschluß des (2n+1) ten Transistors (T 2n+1) mit dem Emitteranschluß des (2n+2)ten Transistors (T 2n+2) und mit einer Stromquelle für den $2^{n-1}$-fachen Strom verbunden ist, daß der Basisanschluß des 2n+1-Transistors (T 2n+1) mit einem Anschluß (En) für das n-te Eingangssignal und daß der Basisanschluß des (2n+2)ten Transistors (T 2n+2) mit einem Anschluß (En) für das n-te inverse Eingangssignal verbunden ist.

2. Anordnung nach Anspruch 1, d a d u r c h   g e -
k e n n z e i c h n e t , daß als Stromquellen ausreichend hochohmige Widerstände vorgesehen sind, deren
Widerstandswerte nach Potenzen von 2 gestuft sind.

3. Anordnung nach Anspruch 1, d a d u r c h   g e -
k e n n z e i c h n e t , daß dem positiveren Potential
der binären Eingangssignale (E1 ... En) der logische
Eins-Zustand zugeordnet ist.

1/2

FIG 1

## FIG 2   2/2

## FIG 3

Europäisches
Patentamt

**EUROPÄISCHER RECHERCHENBERICHT**

| | EINSCHLÄGIGE DOKUMENTE | | KLASSIFIKATION DER ANMELDUNG (Int. Cl.⁻) |
|---|---|---|---|
| Kategorie | Kennzeichnung des Dokuments mit Angabe, soweit erforderlich, der maßgeblichen Teile | betrifft Anspruch | |
| P | EP - A - 0 005 808 (SIEMENS)<br><br>* Das ganze Dokument *<br><br>-- | 1-3 | H 03 K  4/02<br>H 04 L 25/49<br>G 06 F  7/14 |
| | US - A - 3 916 215 (GASKILL et al)<br><br>* Figuren 15,16,12; Zusammen-<br>fassung; Spalte 5, Zeile 10 bis<br>Spalte 8, Zeile 22 *<br><br>-- | | |
| P | ELECTRONICS, Band 52, Nr. 24,<br>November 1979,<br>New York, US,<br>B. BLOOD et al.: "10-ns monolithic<br>d-a converter keeps bipolar drive<br>circuits hustling", Seiten 140-144<br><br>* Seite 142 *<br><br>---- | 1 | RECHERCHIERTE SACHGEBIETE (Int. Cl.³)<br><br>H 03 K<br>H 04 L<br>G 06 G |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde
   liegende Theorien oder
   Grundsätze
E: kollidierende Anmeldung
D: in der Anmeldung angeführtes
   Dokument
L: aus andern Gründen
   angeführtes Dokument
&: Mitglied der gleichen Patentfamilie, übereinstimmendes
   Dokument

Der vorliegende Recherchenbericht wurde für alle Patentansprüche erstellt.

| Recherchenort | Abschlußdatum der Recherche | Prüfer |
|---|---|---|
| Den Haag | 23-12-1980 | GYSEN |

EPA form 1503.1  06.78